# EUROPEAN PATENT SPECIFICATION

(11) **EP 2 320 505 B1**
(45) Date of publication and mention of the grant of the patent: **24.12.2014**
(21) Application number: 09809604.3
(22) Date of filing: 28.08.2009
(51) Int. Cl.: H01M 8/04, H01M 8/10

(54) **FUEL BATTERY POWER GENERATION SYSTEM**
BRENNSTOFFZELLEN-ENERGIEERZEUGUNGSSYSTEM
SYSTÈME DE GÉNÉRATION DE PUISSANCE POUR BATTERIE À COMBUSTIBLE

(30) Priority: 29.08.2008 JP 2008221401
(43) Date of publication of application: 11.05.2011
(73) Proprietor: Panasonic Corporation, Kadoma-shi Osaka 571-8501 (JP)
(72) Inventor: UMEDA, Takahiro, Osaka-shi, Osaka 540-6207 (JP); YASUMOTO, Eiichi, Osaka-shi, Osaka 540-6207 (JP); UNOKI, Shigeyuki, Osaka-shi, Osaka 540-6207 (JP); SUGAWARA, Yasushi, Osaka-shi, Osaka 540-6207 (JP); SHIBATA, Soichi, Osaka-shi, Osaka 540-6207 (JP); SAKAI, Osamu, Osaka-shi, Osaka 540-6207 (JP)
(74) Representative: Grünecker, Kinkeldey, Stockmair & Schwanhäusser
(86) International application number: PCT/JP2009/004236
(87) International publication number: WO 2010/023949

(56) References cited:
- WO-A1-2008/035175
- WO-A2-2007/040576
- JP-A- 2005 259 368
- JP-A- 2007 066 582
- JP-A- 2007 207 669
- JP-A- 2007 207 671
- JP-A- 2008 077 911
- US-A1- 2005 118 466
- US-A1- 2008 026 268
- US-A1- 2008 096 066

## Description

### Technical Field

The present invention relates to a fuel cell power generation system configured to activate an oxidant electrode of which catalytic activity is deteriorated by impurities contained in an oxidant gas, thereby enhancing efficiency of power generation and durability of a fuel cell.

### Background Art

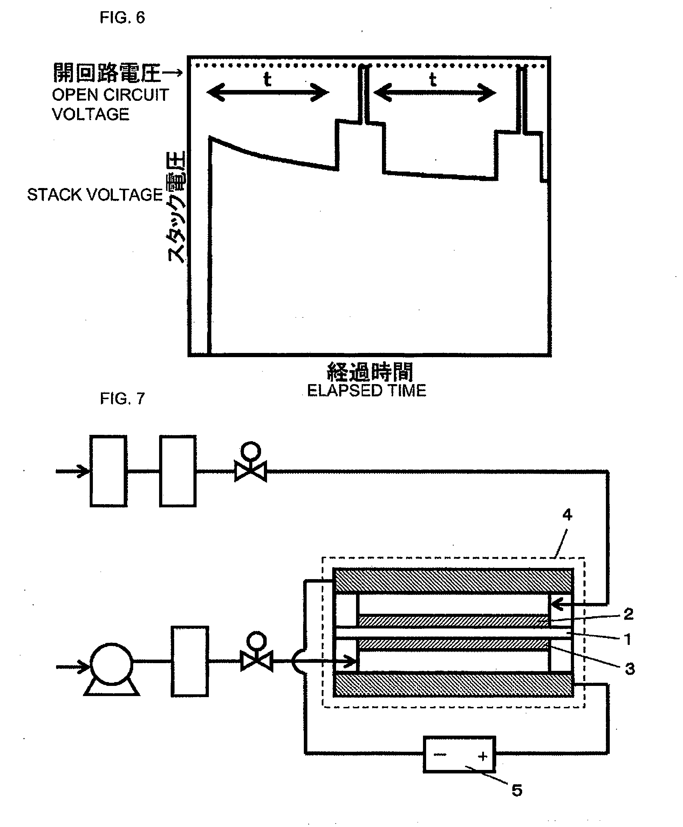

As shown in Fig. 7, a related art general fuel cell power generation system includes a fuel cell 4 including an electrolyte 1 sandwiched between a fuel electrode 2 and an oxidant electrode 3, and generates electric power by supplying a fuel gas including at least hydrogen to the fuel electrode 2 and supplying an oxidant gas including at least oxygen to the oxidant electrode 3.

Air (an atmosphere) is usually used for an oxidant gas. However, air contains various impurities in many cases. Some of the impurities are substances adhered to the oxidant electrode 3, to thus deteriorate activity of a catalyst of the oxidant electrode 3, and hinder occurrence of a chemical reaction required for power generation, thereby decreasing an output voltage of the fuel cell 4.

In order to remove impurities adhered to the oxidant electrode 3, the related art fuel cell power generation system includes, for example, an external power supply 5 except for a power generation circuit. The external power supply 5 is electrically connected to the fuel cell 4, and a voltage is applied to the fuel cell 4 during halting of power generation such that the oxidant electrode 3 to which impurities remain adhered becomes a positive electrode. An electric potential of the oxidant electrode 3 is made higher than a natural electric potential for a given period of time, thereby oxidizing the impurities adhered to the oxidant electrode 3 and desorbing the impurities from the oxidant electrode 3 (see Patent Document 1).

### Related Art Documents

### Patent Documents

Patent Document 1: JP-A-2005-259368

WO 2007/040576 A2 relates to a decontamination procedure for a fuel cell power plant. US 2008/096066 A1 relates to a power supply unit. WO 2008/035175 A1 and US 2008/026268 A1 relate to a fuel cell system. US 2005/0118466 A1 relates to a method for initial activation of a polymer electrolyte fuel cell.

### Summary of the Invention

### Problem to be Solved by the Invention

However, a method for making the electric potential of the oxidant electrode higher by use of the external power supply involves a necessity for providing an external power supply, such as a secondary cell, as well as complicating a configuration of a system, thus raising a problem of non-economic.

The present invention solves the problem of the related art, and an object thereof is to provide a fuel cell power generation system capable of removing impurities adhered to an oxidant electrode without use of an external power supply and by a simple structure.

### Means for Solving the Problem

The present invention provides a fuel cell power generation system as defined in claim 1.

According to the configuration of the present invention, the determination unit determines the timing at which the output control unit applies the predetermined voltage or more before an irreversible voltage fall is caused by impurities. Therefore, deterioration of efficiency of power generation, caused by a voltage fall, is prevented. Further, the output control unit which applies the predetermined voltage or more to the oxidant electrode is activated with no electric power supplied to the outside of the fuel cell power generation system, thereby increasing the electric potential of the oxidant electrode without a necessity for an external power supply to thereby oxidize, desorb, and remove impurities adhered to the oxidant electrode. It is possible to provide a durability-enhanced fuel cell power generation system that enables activation of a fuel cell and maintenance of desired performance.

### Further advantageous embodiments are defined in claims 2 - 11.

### Advantages of the Invention

The present invention enables provision of a fuel cell power generation system that can remove impurities adhered to an oxidant electrode without use of an external power supply and by means of a simple structure, to thus activate a fuel cell, and that exhibits superior efficiency of power generation and durability.

### Brief Description of the Drawings

Fig. 1 is a schematic view of a fuel cell power generation system according to first through fifth embodiments of the present invention.
Fig. 2 is a flowchart showing a method for operating a fuel cell power generation system of the second illustrative embodiment.
Fig. 3(a) is a graph showing a behavior of a stack voltage of the fuel cell power generation system when the fuel cell is not brought into an open circuit state, and Fig. 3(b) is a graph showing the behavior of the stack voltage of the fuel cell power generation system of the second illustrative embodiment.
Fig. 4 is a flowchart showing a method for operating a fuel cell power generation system of a third embodiment.
Fig. 5 is a flowchart showing a method for operating a fuel cell power generation system of a fourth illustrative embodiment.
Fig. 6 is a graph showing a behavior of a stack voltage appearing when operation is performed under the fuel cell power generation system operating method.
Fig. 7 is a general schematic view of a related-art fuel cell power generation system.

### Mode for Carrying Out the Invention

In a first invention, a fuel cell power generation system is defined according to claim 1. According to the present invention, the determination unit determines timing at which the output control unit applies the predetermined voltage or more before an irreversible voltage fall is caused by impurities. Therefore, deterioration of efficiency of power generation, caused by a voltage fall, is prevented. Further, the output control unit which applies the predetermined voltage or more to the oxidant electrode is activated with no electric power supplied to the outside of the fuel cell power generation system, thereby increasing the electric potential of the oxidant electrode without a necessity for an external power supply to thereby oxidize, desorb, and remove impurities adhered to the oxidant electrode. It is possible to provide a durability-enhanced fuel cell power generation system that enables activation of a fuel cell and maintenance of desired performance.

A second invention is based on the first invention, wherein the predetermined voltage or more is a voltage higher than that applied during normal operation of the fuel cell. It is possible to obtain a fuel cell power generation system that can increase an electric potential of the oxidant electrode to thereby remove impurities adhered to the oxidant electrode through oxidation and in turn make it possible to make the fuel cell active.

A third invention is based on the first invention, wherein the predetermined voltage or more is a voltage required for oxidizing impurities adhered to the oxidant electrode. It is possible to obtain a fuel cell power generation system that can increase an electric potential of the oxidant electrode to thereby remove impurities adhered to the oxidant electrode through oxidation and in turn make it possible to make the fuel cell active.

A fourth invention is based on any one of the first through third inventions, wherein the predetermined voltage or more is a voltage obtained by disconnecting a load from the fuel cell so as to bring the fuel cell into an open circuit state. It is possible to obtain a fuel cell power generation system that can increase an electric potential of the oxidant electrode to thereby remove impurities adhered to the oxidant electrode through oxidation and in turn make it possible to make the fuel cell active.

A fifth invention is based on any one of the first through third inventions, wherein the predetermined voltage or more is a voltage obtained by making a load of the fuel cell power generation system small. It is possible to obtain a fuel cell power generation system that can increase an electric potential of the oxidant electrode to thereby remove impurities adhered to the oxidant electrode through oxidation and in turn make it possible to make the fuel cell active.

A sixth invention is based on any one of the first through fifth inventions, wherein the output control unit applies the predetermined voltage or more to the oxidant electrode in a state in which a fuel gas is supplied to the fuel electrode, an oxidant gas is supplied to the oxidant electrode, and no electric power is supplied to the outside of the fuel cell power generation system. It is possible to obtain a fuel cell power generation system that can increase an electric potential of the oxidant electrode to thereby remove impurities adhered to the oxidant electrode through oxidation and in turn make it possible to make the fuel cell active.

A seventh invention is based on any one of the first through fifth inventions, wherein the output control unit applies the predetermined voltage or more to the oxidant electrode in a state in which supply of the fuel gas to the fuel electrode is stopped, supply of the oxidant gas to the oxidant electrode is stopped, and no electric power is supplied to the outside of the fuel cell power generation system. It is possible to obtain a fuel cell power generation system that can increase an electric potential of the oxidant electrode to thereby remove impurities adhered to the oxidant electrode through oxidation and in turn make it possible to make the fuel cell active.

An eighth invention is based on any one of the first through seventh inventions, wherein the determination unit comprises an power generation time integration unit configured to integrate a power generation time of the fuel cell, and is configured to determine the timing at which the predetermined voltage or more is applied to the oxidant electrode based on an integrated time obtained by the power generation time integration unit. It is possible to obtain a fuel cell power generation system capable of removing impurities adhered to the oxidant electrode by means of a very simple configuration; namely, integration of a power generation time, to thus make it possible to make the fuel cell active.

A ninth invention is based on any one of the first through seventh inventions and further comprises an impurity concentration detection unit configured to detect a concentration of impurities contained in the oxidant gas, wherein the determination unit calculates an integrated amount of impurities supplied to the oxidant electrode based on the concentration of impurities detected by the impurity concentration detection unit and an amount of oxidant gas supplied to the oxidant electrode, and determines the timing at which the predetermined voltage or more is applied to the oxidant electrode. As a result, it is possible to detect a concentration of impurities in the oxidant gas in real time and remove the impurities adhered to the oxidant electrode according to an actual integrated amount of impurities, to thus make it possible to make the fuel cell active. Therefore, it is possible to obtain a fuel cell power generation system that exhibits much superior efficiency of power generation and durability.

A tenth invention is based on any one of the first through ninth inventions, wherein the impurities contained in the oxidant gas are sulfur compounds. The sulfur compounds that poison the oxidant electrode, to thus deteriorate the activity of the oxidant electrode, can be oxidized and removed at a neighborhood of a natural potential where the sulfur compounds are likely to be oxidized, by applying the predetermined voltage or more to the oxidant electrode. Therefore, it is possible to obtain a fuel cell power generation system that exhibits much superior efficiency of power generation and durability.

An eleventh invention is based on any one of the first through seventh inventions and further comprises a voltage detection unit configured to detect a voltage of the fuel cell, wherein the determination unit calculates an integrated amount of impurities supplied to the oxidant electrode based on the voltage detected by the voltage detection unit, and determines the timing at which the predetermined voltage or more is applied to the oxidant electrode. As a result, even when means for directly detecting impurities is not available, an active state of the oxidant electrode is determined from a voltage of the fuel cell that decreases in response to the integrated amount of impurities. When the voltage is determined to be lower than a voltage acquired in normal times, the fuel call can be made active. Therefore, the fuel cell power generation system can be further simplified.

A twelfth invention is based on the eleventh invention, wherein, when a number of times the predetermined voltage or more is applied to the oxidant electrode exceeds a predetermined number of time and when the voltage detected by the voltage detection unit falls below the predetermined voltage for a given period of time, the output control unit is configured to: stop power generation of the fuel cell and stops at least the supply of the oxidant gas so as to decrease an electric potential of the oxidant electrode to a predetermined electric potential; thereafter again supply the oxidant gas so as to bring the fuel cell into an open circuit state for a given period of time; and thereafter start power generation of the fuel cell. If the voltage is not recovered even when the fuel cell is brought into an open circuit state in the middle of power generation, start-up operation is stopped, thereby decreasing the electric potential of the oxidant electrode from a high electric potential (a natural electric potential) to a low electric potential, thereby removing various impurities through oxidation. Hence, the activity of the fuel cell can further be recovered.

A thirteenth invention is based on the fourth invention, wherein the output control unit brings the fuel cell into the open circuit state while a pressure of the fuel gas supplied to the fuel electrode is maintained so as to become lower than a pressure of the oxidant gas supplied to the oxidant electrode. The amount of hydrogen cross-leaking from the fuel electrode toward the oxidant electrode is thereby decreased, whereby the electric potential of the oxidant electrode can further be increased. Therefore, the impurities adhered to the oxidant electrode are further oxidized, so that the oxidant electrode can be made more active.

A fourteenth invention is based on the fourth invention, wherein the output control unit brings the fuel cell into the open circuit state while a pressure of the fuel gas is maintained so as to become lower than a pressure of the oxidant gas supplied to the oxidant electrode by decreasing a flow rate of the fuel gas supplied to the fuel electrode, and the flow rate of the fuel gas supplied to the fuel electrode is decreased only during a period in which power generation is temporarily suspended. Therefore, the amount of hydrogen cross-leaking from the fuel electrode to the oxidant electrode is decreased, so that the electric potential of the oxidant electrode can be increased further. Hence, impurities adhered to the oxidant electrode are more oxidized, so that the oxidant electrode can be made more active.

A fifteenth invention is based on the thirteenth invention and further includes a fuel cell bypass line configured to bypass the fuel electrode of the fuel cell, wherein the output control unit brings the fuel cell into the open circuit state while the pressure of the fuel gas is maintained so as to become lower than the pressure of the oxidant gas supplied to the oxidant electrode by supplying a part of the fuel gas to the fuel cell bypass line thereby decreasing the flow rate of the fuel gas supplied to the fuel electrode. Further, a part of the fuel gas is supplied to the fuel cell bypass line only in a period during which power generation is temporarily suspended, to thus decrease the pressure of the fuel gas supplied to the fuel electrode, and the fuel gas is supplied while a total amount of fuel gas generated by a fuel processing unit is maintained at a given level. Therefore, control of the fuel processing unit can be simplified.

A sixteenth invention is based on any one of the first through seventh inventions, wherein the output control unit is configured to: control a supply amount of the fuel gas and supply amount of oxidant gas according to fluctuations in a load of the fuel cell, thereby controlling an output of the fuel cell; forcefully decrease the output of the fuel cell at the time determined by the determination unit, thereby decreasing the amount of fuel gas and the amount of oxidant gas to predetermined supply amounts under a predetermined output or less; and thereafter apply the predetermined voltage or more to the oxidant electrode. With this configuration, the oxidant electrode is activated, and the power generation is stopped at a low output at which a consumed amount of fuel gas and a consumed amount of oxidant gas are small. Therefore, the consumed amount of fuel gas and the consumed amount of oxidant gas, which are not used for power generation, can be minimized, so that the fuel cell can be made active with superior efficiency.

Embodiments of the present invention are hereunder described by reference to the drawings. The present invention shall not be limited by the embodiments.

### (First Embodiment)

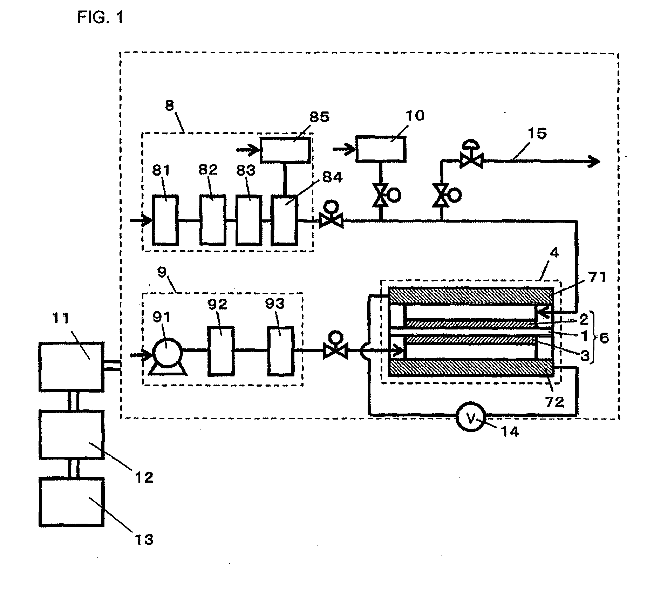

Fig. 1 is a general schematic view of a fuel cell power generation system of a first embodiment of the present invention.

A fuel cell power generation system of the first embodiment of the present invention has a fuel cell 4 having a membrane electrode assembly 6. The membrane electrode assembly 6 includes a solid polymer electrolyte 1 (hereinafter mentioned as an "electrolyte 1 ") that is made of perfluorocarbon sulfonate polymer exhibiting hydrogen ion conductivity and that is sandwiched between a fuel electrode 2 and an oxidant electrode 3. The fuel cell power generation system can generate electric power by supplying a fuel gas including at least hydrogen to the fuel electrode 2 and supplying an oxidant gas including at least oxygen to the oxidant electrode 3.

The fuel cell power generation system includes the fuel cell 4; a power output unit such as an inverter that supplies a.c. electric power to at least an external load and an internal load, like a power supply of auxiliary machinery and a control board.

Each of the fuel electrode 2 and the oxidant electrode 3 includes: a catalyst layer that is formed from a mixture of a catalyst that is made by means of highly porous oxidation-resistant carbon carrying precious metal, like platinum, and a polymer electrolyte exhibiting hydrogen ion conductivity; and a gas diffusion layer that is stacked on the catalyst layer and that exhibits air permeability and electron conductivity. The fuel electrode 2 is formed from platinum-ruthenium alloy catalyst exhibiting CO resistance. The catalyst used for the fuel electrode 2 shall not be limited to the platinum-ruthenium alloy.

The gas diffusion layer is formed from carbon paper given water repellency. The gas diffusion layer shall not be limited to the carbon paper and can be made of carbon cloth or nonwoven carbon fabric.

A pair of gaskets are placed in a neighborhood of the membrane electrode assembly 6 made by sandwiching the electrolyte 1 between the fuel electrode 2 and the oxidant electrode 3, in order to prevent mixing or leakage of gases. The fuel electrode 2 and the oxidant electrode 3 are sandwiched between a pair of conductive carbon separator plates 71 and 72, thereby making up a single cell. The separator plate 71 having a gas flow channel supplies a fuel gas to the fuel electrode 2 and lets the fuel gas exit from the fuel electrode. The separator plate 72 having a gas flow channel supplies an oxidant gas to the oxidant electrode 3 and lets the gas exit from the oxidant electrode.

Moreover, a plurality of single cells are layered, and a collector plate, an insulation plate, and an end plate are disposed on either end of the stacked cells. These plates are fastened by means of firmly fastening rods, thereby forming a stack. A passageway for supplying and discharging cooling water is laid between the cells. In order to prevent dissipation of heat to the outside of the stack and maintain a stable temperature, a heating insulating material is disposed around the stack.

A fuel processing unit 8 for supplying a fuel gas and an oxidant gas supply unit 9 for supplying an oxidant gas are connected to the fuel cell 4 having the foregoing configuration, thereby constituting a fuel cell power generation system.

The fuel processing unit 8 comprises a desulfurization unit 81 that reforms a source gas, such as a hydrocarbon-containing city gas like methane, to thus supply a fuel gas containing hydrogen, and that adsorbs and removes a sulfur compound contained in odorant; a reforming unit 82 that reforms a hydrocarbon-containing source gas, like methane; a CO shift unit 83 that shifts carbon monoxide (CO) caused by a reforming reaction; and a CO removal unit 84 that additionally, selectively removes CO through oxidation.

After having first undergone desulfurization in the desulfurization unit 81, the source gas is reformed by the reforming unit 82, to thus turn into a fuel gas containing hydrogen. When methane is used as a source gas, a reaction represented by (Chemical Formula 1) occurs in the reforming unit 82 with generation of steam, whereupon about 10% of CO develops along with hydrogen that is a fuel gas.

[Chemical Formula 1] CH₄ + H₂O → CO + 3H₂

A platinum catalyst included in the fuel electrode 2 is poisoned by a nominal amount of CO in an operating temperature range of the fuel cell 4. Activity of the catalyst resultantly decreases. Therefore, as represented by (Chemical Formula 2), CO developed in the reforming unit 82 is shifted into carbon dioxide by the CO shift unit 83. The concentration of carbon dioxide drops to about 5000 ppm. Since the CO removal unit 84 disposed at a downstream position oxides hydrogen of the fuel gas as well as CO, the CO shift unit 83 must decrease the concentration of CO to the minimum possible level.

[Chemical Formula 2] CO + H₂O → CO₂ + H₂

The CO removal unit 84 selectively oxides the remaining CO as represented by (Chemical Formula 3) by means of the air taken in from the atmosphere by a selective oxidation air supply unit 85. The concentration of CO decreases to about 10 ppm or less at which deterioration of activity of the catalyst of the fuel electrode 2 can be prevented.

[Chemical Formula 3] CO + 1/2O₂ → CO₂

The fuel processing unit 8 is not limited to the steam reforming technique, and another hydrogen generation technique, like an automatic thermal technique can also be adopted.

Further, there is adopted a configuration in which an air-bleeding unit 10 for supplying air to the fuel electrode 2 that is in the middle of power generation, is disposed in front of the fuel electrode 2 and in which slightly-remaining influence of CO is further lessened by mixing about 1 to 2% of air into the fuel gas generated by the fuel processing unit 8. The air-bleeding unit 10 can also be omitted according to the concentration of CO contained in the fuel gas.

An oxidant gas supply unit 9 is made up of a blower 91 that takes in an oxidant gas; an impurity removal unit 92 that removes impurities from the oxidant gas; and a humidifier 93 that humidifies the oxidant gas. The oxidant gas supply unit 9 supplies a humidified oxidant gas to the oxidant electrode 3 of the fuel cell 4. The oxidant gas is a generic designation of a gas including at least oxygen (or a gas capable of supplying oxygen). For instance, atmosphere (air) can be mentioned as the gas.

Operation of the fuel cell 4 having the foregoing configuration is now described. A fuel gas is supplied to the fuel electrode 2, and an oxidant gas is supplied to the oxidant electrode 3, whereupon a load is connected to the fuel cell. Thereby, hydrogen contained in the fuel gas supplied to the fuel electrode 2 discharges electrons at a boundary surface between the catalyst layer of the fuel electrode 2 and the electrolyte, to thus become hydrogen ions, as indicated by a reaction formula (Chemical Formula 4).

[Chemical Formula 4] H₂ → 2H⁺ + 2e⁻

Hydrogen ions migrate to the oxidant electrode 3 through the electrolyte 1 and receives electrons at the boundary surface between the catalyst layer of the oxidant electrode 3 and the electrolyte. The thus-received electrons react with oxygen contained in the oxidant gas supplied to the oxidant electrode 3, thereby generating water. The reaction formula is represented as illustrated by (Chemical Formula 5).

[Chemical Formula 5] 1/2O₂ + 2H⁺ + 2e⁻ → H₂O

All reactions are represented by (Chemical Formula 6).

[Chemical Formula 6] H₂ + 1/2O₂ → H₂O

A flow of electrons flowing through the load at this time can be utilized as electric energy of a d.c. Further, since the series of reactions are thermal reactions, reaction heat can be utilized as thermal energy.

In Fig. 1, an output control unit 11 controls an output from the fuel cell 4 according to fluctuations in load. When a larger amount of electric power generated is required as a result of an increase in the load of the fuel cell 4, the amount of source gas supplied to the fuel processing unit 8 is increased, thereby increasing the amount of fuel gas generated. Further, a capability value of the blower 91 is increased, thereby increasing the supply amount of oxidant gas.

Conversely, the power generation system is configured in such a way that, when the amount of electric power generated is not much required, the supply amount of fuel gas or oxidant gas is decreased, thereby decreasing the output.

Incidentally, there are many cases where the atmosphere includes a variety of impurities. For instance, the atmosphere includes sulfur compounds, such as sulfur dioxide included in a volcano or a combustion exhaust gas, a nitrogen oxide much included in combustion exhaust gases from a factory and an automobile, and ammonia that is a malodorous component.

The impurities adversely affect the fuel cell 4. When reached the oxidant electrode 3 while mixed in the oxidant gas, the impurities adhere (adsorb) to a catalyst included in the oxidant electrode 3, thereby impeding a chemical reaction required to generate electric power. For this reason, an output of the fuel cell 4 is sometimes decreased. Of the impurities, the sulfur compound exhibits comparatively strong adsorption force. When a large amount of sulfur compound is accumulated, difficulty is encountered in removing the sulfur compound, which in turn becomes a cause of deterioration of efficiency of power generation or durability of the fuel cell 4.

In the meantime, the oxidation reaction of the impurities can be promoted according to a polarity potential of the oxidant electrode 3. A reaction of water with air can easily desorb the impurities adhered to the oxidant electrode 3 from the oxidant electrode 3.

The fuel cell power generation system of the embodiment has at least the fuel electrode 2 that is supplied with a fuel gas including at least hydrogen; the oxidant electrode 3 that is supplied with an oxidant gas including at least oxygen; the fuel cell 4 that includes the electrolyte 1 having the fuel electrode 2 and the oxidant electrode 3; the output control unit 11 that applies a predetermined voltage or more to the oxidant electrode 3 in a state in which electric power is not supplied to the outside of the fuel cell power generation system; and a determination unit 12 that determines timing for applying the predetermined voltage or more from the output control unit 11.

The fuel cell power generation system is equipped with a power output unit (not shown), such as an inverter, for supplying a.c. power to an external load (not shown) provided outside the fuel cell power generation system. The fuel cell 4 supplies electric power to the external load and internal load (not shown), such as auxiliary machinery include in the fuel cell power generation system or a power supply of a control substrate. A state in which electric power is not supplied to the outside of the fuel cell power generation system is a state in which the external load is disconnected while all of the internal loads or some of the internal loads remain intact.

In the configuration of the present embodiment, the determination unit 12 determines timing at which the output control unit 11 is to apply a predetermined voltage or more before an irreversible voltage fall is caused by impurities, according to a result of a determination made by the determination unit 12. Therefore, deterioration of efficiency of power generation, which would otherwise be caused by a voltage fall, is prevented. Further, the output control unit 11 which applies a predetermined voltage or more to the oxidant electrode is activated with no electric power supplied to the outside of the fuel cell power generation system, thereby increasing the electric potential of the oxidant electrode 3 without a necessity for an external power supply to thereby oxidize, desorb, and remove impurities adhered to the oxidant electrode. It is possible to provide a durability-enhanced fuel cell power generation system that enables activation of the fuel cell 4 and maintenance of desired performance.

The predetermined voltage or more is a voltage that is higher than that acquired during normal operation of the fuel cell 4. It is possible to obtain a fuel cell power generation system that increases the electric potential of the oxidant electrode 3 to thus remove the impurities adhered to the oxidant electrode 3 through oxidation, thereby making it possible to make the fuel cell 4 active.

Further, the predetermined voltage or more is a voltage required to oxidize the impurities adhered to the oxidant electrode 3. It is possible to obtain a fuel cell power generation system that makes it possible to remove the impurities adhered to the oxidant electrode 3 through oxidation, thereby making the fuel cell 4 active.

The predetermined voltage or more is a voltage obtained by making a load of the fuel cell power generation system low, It is possible to obtain a fuel cell power generation system that makes it possible to bring the oxidant electrode 3 into a high potential, to thus remove the impurities adhered to the oxidant electrode 3 through oxidation and to thereby make the fuel cell 4 active.

Further, the predetermined voltage or more is a voltage obtained when the fuel cell 4 is brought into an open circuit state as a result of the load on the fuel cell being disconnected. It is possible to obtain a fuel cell power generation system that makes it possible to bring the oxidant electrode 3 into a high potential, to thus remove the impurities adhered to the oxidant electrode 3 through oxidation and to thereby make the fuel cell 4 active.

An explanation is hereunder given to a configuration for oxidizing and removing the impurities adhered to the oxidant electrode 3 by use of the predetermined voltage or more that is acquired when the load of the fuel cell 4 is brought into an open circuit state as a result of the load on the fuel cell being disconnected.

An electrode potential at which an oxidation reaction is promoted changes according to types of impurities. A sulfur compound, such as sulfur dioxide, is likely to be oxidized at an electrode potential that is higher than that acquired during generation of electric power. The present inventors found the followings. Specifically, there is set an open circuit state in which the load is disconnected from the fuel cell 4 while the output control unit 11 is supplying a fuel gas to the fuel electrode 2 and an oxidant gas to the oxidant electrode 3. An electrode potential that is higher than an electrode potential achieved during power generation of the fuel cell is achieved even at a natural potential achieved in the open circuit state. Most of the sulfur compound adhered to the oxidant electrode 3 can be oxidized, and the sulfur compound oxidized by the oxidant gas being continually supplied can be desorbed and removed from the oxidant electrode 3.

Therefore, in the present invention, an attention is paid to the sulfur compound that causes an irreversible voltage fall when accumulated to a certain extent. The fuel cell 4 is brought into an open state at a small integrated amount of sulfur compound which does not cause an irreversible voltage fall, thereby bringing the oxidant electrode 3 into a high electric potential (a natural electric potential). Thus, the sulfur compound adhered to the oxidant electrode 3 is oxidized and removed, thereby activating the fuel cell 4.

In relation to a threshold value of an integrated amount of impurity supplied to the oxidant electrode 3 when the fuel cell 4 is brought into an open circuit state, a limit amount that does not cause an irreversible voltage fall and at which the voltage recovers so long as the natural potential is retained for one second to ten minutes is previously determined through a test. Further, an integrated amount achieved before the limit amount is taken as a threshold value.

So long as the threshold value of the integrated amount of impurity is a value that meets the objective of the limit amount, a direct amount of impurities can be the threshold value or an indirect amount equivalent to the amount of impurities can also be the threshold value. There is provided the determination unit 12 that determines a period at which the fuel cell is brought into an open circuit state, according to the threshold value for the integrated amount of impurities.

According to the configuration of the present embodiment, the determination unit 12 determines a period at which the fuel cell is brought into an open circuit state before the impurities cause an irreversible voltage fall. Hence, a fall in efficiency of power generation, which would otherwise be caused by a voltage fall, does not occur. Moreover, the output control unit 11 that brings the fuel cell 4 into an open circuit state at a period determined by the determination unit 12 brings the oxidant electrode 3 into a high electric potential without a necessity for an external power supply. Impurities adhered to the oxidant electrode 3 are oxidized, and the impurities oxidized by the oxidant gas are desorbed and removed. Thus, it is possible to obtain a durability-enhanced fuel cell power generation system that can activate the fuel cell 4 and maintain desirable performance.

A specific example for obtaining a threshold value for an integrated amount of impurities is described hereunder.

The integrated amount of impurities is added with elapse of a power generation time of the fuel cell 4. Accordingly, the determination unit 12 has a power generation time integration unit (not shown) that integrates a power generation time of the fuel cell 4. When the integration time acquired by the power generation time integration unit has become equal to the threshold value for the integrated amount of impurities, the determination unit 12 determines timing at which the fuel cell 4 is to be brought into an open circuit state. The output control unit 11 disconnects, at a period determined by the determination unit 12, the load of the fuel cell 4 with the fuel gas supplied to the fuel electrode 2 and with the oxidant gas supplied to the oxidant electrode 3, thereby bringing the fuel cell into an open circuit state.

According to the present embodiment, it is possible to obtain a fuel cell power generation system that enables activation of the fuel cell 4 by removing the impurities adhered to the oxidant electrode 3 according to a very simple configuration that integrates a power generation time.

In the foregoing explanation, the output control unit 11 supplies the fuel gas to the fuel electrode 2 and the oxidant gas to the oxidant electrode 3, thereby bringing the fuel cell into an open circuit state. However, the essential requirement is to apply a predetermined voltage or more to the oxidant electrode 3 with no electric power supplied to the outside of the fuel cell power generation system and without bringing the fuel cell into an open circuit state. It is possible to obtain a fuel cell power generation system that brings the oxidant electrode 3 into a high electric potential to thereby remove the impurities adhered to the oxidant electrode 3 through oxidation, thereby activating the fuel cell.

The output control unit 11 can also be configured in such a way that, with the supply of fuel gas to the fuel electrode 2 and the supply of oxidant gas to the oxidant electrode 3 stopped and with no electric power supplied to the outside of the fuel cell power generation system, the predetermined voltage or more is supplied to the oxidant electrode 3. Even in a state which supplying the fuel gas and the oxidant gas is suspended, a predetermined voltage is still applied by the gases supplied to the fuel electrode 2 and to the oxidant electrode 3 immediately before halting the gas supply.

### (Second Illustrative Embodiment) not part of the present invention

Fig. 1 shows a general configuration of a fuel cell power generation system of a second illustrative embodiment.

The power generation time integration unit provided in the determination unit 12 of the first embodiment is deleted from the fuel cell power generation system of the second illustrative embodiment. The system is provided with an impurity concentration detection unit 13 for detecting a concentration of impurities included in the oxidant gas instead. The other constituent elements are assigned the same reference numerals, and their explanations are omitted for brevity.

The determination unit 12 connected to the output control unit 11 computes a time that will elapse before the fuel cell 4 is brought into an open state, from a concentration of impurities in a flow subsequent to the impurity removal unit 92 estimated from an impurity removal ratio of the impurity removal unit 92, a supply amount of oxidant gas, and an integrated amount of impurities supplied to the oxidant electrode. The determination unit 12 can send to the output control unit 11 a timing command for bringing the fuel cell 4 into an open circuit state.

In relation to the concentration of impurities in the atmosphere, an average concentration of impurities acquired in normal times is previously input to the determination unit 12, by reference to impurity information about a location where the fuel cell power generation system is installed. Alternatively, the concentration of impurities in the atmosphere can be automatically acquired by way of a communication unit, the Internet, as required. In the present illustrative embodiment, the fuel cell power generation system is equipped with the impurity concentration detection unit 13 and configured so as to detect a real-time concentration of impurities in the oxidant gas acquired in the installation environment. A sulfur dioxide gas sensor capable of detecting sulfur dioxide is used for the impurity concentration detection unit 13.

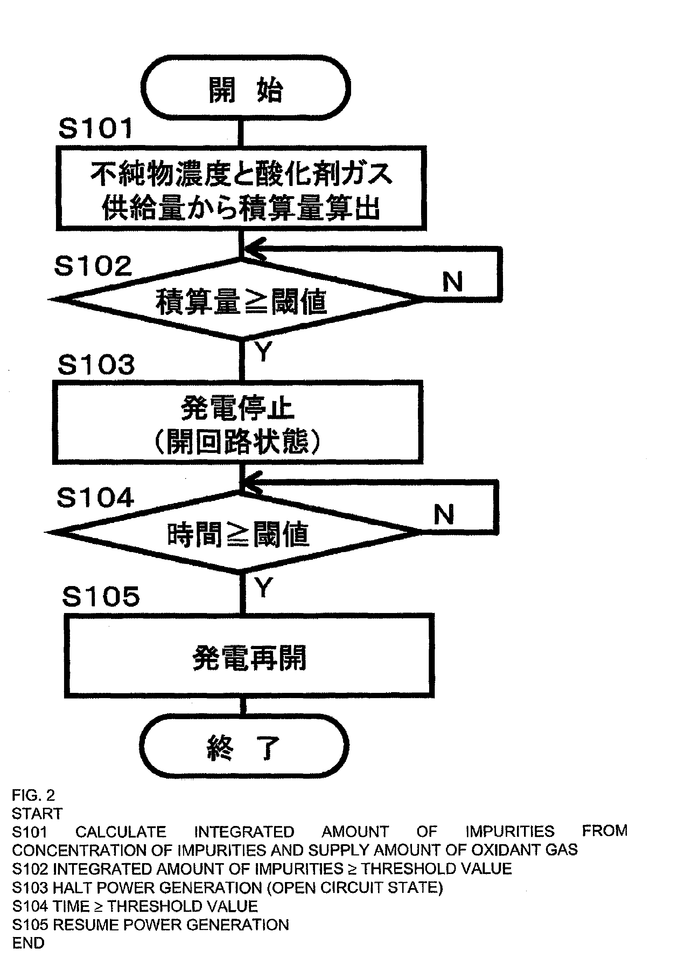

An operation sequence of the fuel cell power generation system of the illustrative embodiment is now described by reference to a flowchart shown in Fig. 2.

First, the determination unit 12 calculates an integrated amount of impurities (sulfur dioxide) supplied to the oxidant electrode, from the concentration of sulfur dioxide detected by the impurity concentration detection unit 13, a rate of removal of sulfur dioxide achieved in the impurity removal unit 92, and a amount of oxidant gas supplied to the oxidant electrode 3 by the blower 91 from initiation of power generation, thereby determining timing at which the fuel cell 4 is to be brought into an open circuit state (step S101).

It is now determined whether or not the integrated amount of impurities determined in step 101 is larger than a threshold value of an integrated amount of impurities that has previously been determined by way of experiment (step 102).

When the integrated amount of impurities is in excess of the threshold value, the output control unit 11 maintains an open circuit state (for about one second to ten minutes) in which the load is disconnected from the fuel cell 4 with the fuel gas supplied to the fuel electrode 2 and the oxidant gas supplied to the oxidant electrode 3 (step 103). Since power generation of the fuel cell is consequently brought into a halt state, power generation is depicted as being halted in Fig, 2.

When the fuel cell is brought into the open state for about one second to ten minutes, the load is connected, and power generation is started again (steps 104 and 105).

As in the first embodiment, activity of the fuel cell 4 is recovered as a result of having been brought into an open circuit state, so that efficiency of power generation and durability of the fuel cell power generation system can be enhanced.

Carbon contained in a catalyst layer of the oxidant electrode 3 becomes more susceptible to corrosion and oxidation at a high electric potential, to thus become deteriorated. However, in the fuel cell power generation system of the present illustrative embodiment, the electric potential of the electrodes increases up to a natural potential as a result of the fuel cell being brought into an open circuit state. Therefore, oxidation of carbon making up the catalyst layer can be prevented.

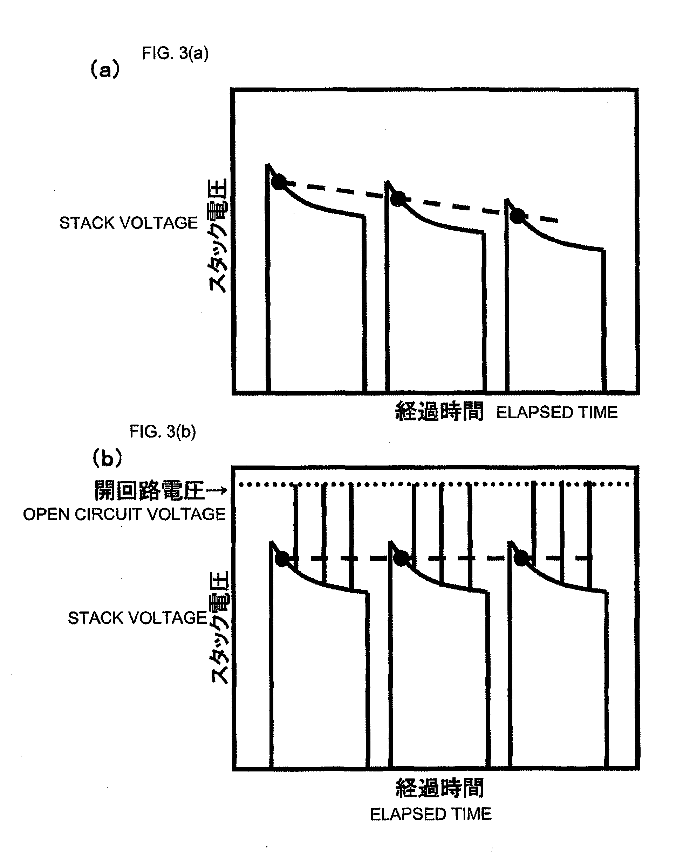

In order to ascertain an advantage of the fuel cell power generation system of the embodiment having the foregoing configuration, a simulation was actually carried out with an oxidant gas including impurities (sulfur dioxide) supplied to the oxidant electrode 3 of the fuel cell 4. The concentration of sulfur dioxide supplied was set to a concentration achieved after removal of an average concentration of impurities included in an actual atmosphere by the impurity removal unit 92. Fig. 3 shows a test result.

Fig. 3(a) shows a shift in stack voltage occurred when power generation is performed with the fuel cell not held in an open circuit state and with impurities being supplied. The drawing shows that a voltage (designated by solid circles) achieved after elapse of a given time since power generation was started gradually decreases. A conceivable reason for this is that sulfur dioxide in the oxidant gas is gradually built up in the oxidant electrode 3, thereby poisoning the catalyst, so that a chemical reaction is hindered, thereby causing deterioration of activity of the fuel cell.

In the meantime, Fig. 3(b) shows that the stack voltage acquired under the operating method of the present invention shifts constantly without involvement of occurrence of a decrease in the voltage (designated by solid circles in the drawing) after elapse of a given time since power generation was started, as a result of the fuel cell being periodically brought into an open circuit state in the middle of power generation according to the integrated amount of impurities.

Consequently, the fuel cell power generation system of the present illustrative embodiment can detect the concentration of impurities in oxidant gas in real time and remove the impurities adhered to the oxidant electrode 3 through oxidation according to the integrated amount of actual impurities, thereby activating the fuel cell 4. Therefore, efficiency of power generation and durability of the fuel cell 4 can be enhanced.

### (Third Embodiment)

Fig. 1 shows a general configuration of a fuel cell power generation system of a third embodiment of the present invention.

The impurity concentration detection unit 13 shown in Fig. 1 is deleted from the fuel cell power generation system of the third embodiment of the present invention. The fuel cell power generation system is equipped with a voltage detection unit 14 that detects a voltage of the fuel cell 4. When a voltage detected by the voltage detection unit 14 has fallen below, for a given period of time, a predetermined voltage determined by an output of the fuel cell 4, an integrated time output from the power generation time integration unit, and the time elapsed since power generation was started, the determination unit 12 determines the time as timing for bringing the fuel cell 4 into an open circuit state. The fuel cell power generation system of the third embodiment is analogous to the fuel cell power generation system of the second embodiment except the above. Detailed explanations are given to a difference between the second embodiment and the third embodiment.

As mentioned above, the voltage of the fuel cell 4 is decreased by impurities. So long as the concentration of impurities is equal to or less than a predetermined concentration, the voltage shifts according to the concentration. For this reason, so long as the voltage is monitored, it is possible to determine the concentration of impurities and an integrated amount of impurities to a certain extent even when means, like the impurity concentration detection unit 13, is not provided.

Consequently, if consideration is given to a voltage that gradually decreases in conjunction with durability regardless of impurities and to a voltage that gradually decreases for reasons of a recovery effect immediately after start-up of the fuel cell power generation system, a threshold value equivalent to the integrated amount of impurities can be determined from the voltage detected by the voltage detection unit 14.

In the third embodiment, the determination unit 12 calculates, from the voltage detected by the voltage detection unit 14, an integrated amount of impurities that are included in the oxidant gas and that are supplied to the oxidant electrode 3. Further, the determination unit determines timing at which the fuel cell 4 is to be brought into an open circuit state. Even when the impurity concentration detection unit 13 is not provided, the active state of the oxidant electrode 3 is determined from the voltage of the fuel cell 4 that decreases in response to the integrated amount of impurities. When the voltage is lower than the voltage of the fuel cell achieved in normal times, the fuel cell 4 is brought into an open circuit state. Therefore, the fuel cell power generation system can further be simplified.

Further, there is realized the following configuration. Specifically, when the number of times the fuel cell 4 is brought into an open circuit state since power generation was started has surpassed a predetermined number of times and when the voltage detected by the voltage detection unit 14 still falls below the predetermined voltage for a given period of time, the output control unit 11 disconnects the load from the fuel cell 4, thereby forcefully stopping power generation of the fuel cell 4. After the electric potential of the oxidant electrode 3 is decreased to a predetermined electric potential by suspending at least an oxidant gas supply, the fuel cell 4 is re-started and brought into an open circuit state for a given period of time, and power generation is subsequently resumed.

It is not always necessary to stop the fuel gas supply. It is desirable to avoid stopping the fuel gas supply from the viewpoint of preventing useless energy consumption, which would otherwise arise when the fuel processing unit 8 that remains stably hot at a high temperature is deactivated.

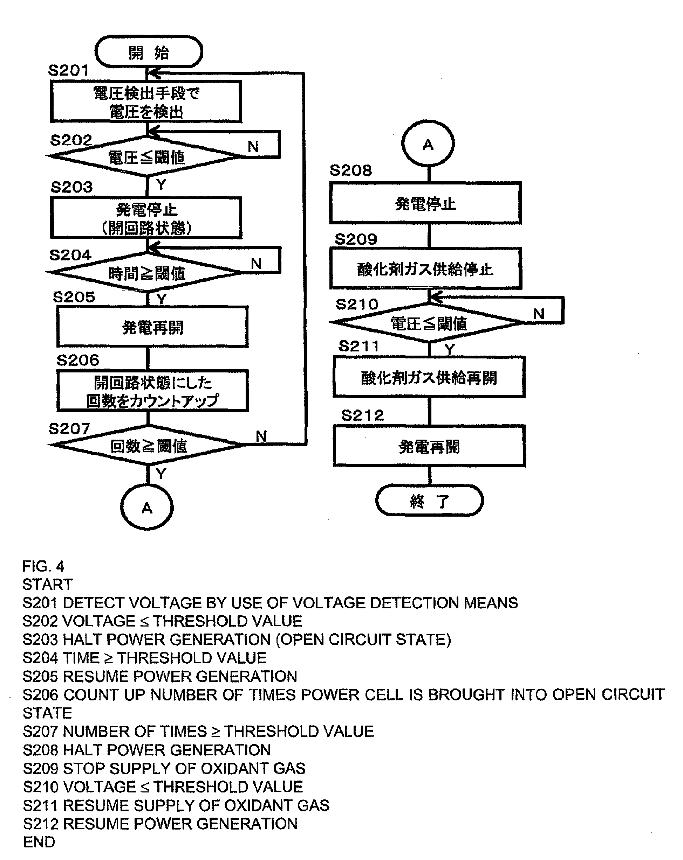

Fig. 4 shows a flowchart of operation of a method for operating the fuel cell power generation system of the third embodiment of the present invention.

First, the voltage detection unit 14 monitors the voltage of the fuel cell 4 (step 201).

The determination unit 12 determines whether or not the voltage detected by the voltage detection unit 14 has become lower than a threshold value that is a voltage acquired at timing when the integrated amount of impurities, which has not yet reached a limit amount at which an irreversible voltage fall occurs, has adhered to the oxidant electrode 3. The determination unit 12 determines timing at which the fuel cell 4 is to be brought into an open circuit state (step 202). The output control unit 11 maintains, for a predetermined period of time (about one second to 10 minutes), an open circuit state in which the load is disconnected from the fuel cell 4 with the fuel gas supplied to the fuel electrode 2 and the oxidant gas supplied to the oxidant electrode 3 when the voltage detected by the voltage detection unit 14 is under the threshold value (step 203). Since power generation of the fuel cell is consequently brought into a halt, power generation is depicted as being halted in Fig. 4.

After the fuel cell has been held in an open circuit state for about one second to ten minutes, the load is again connected to the fuel cell 4, thereby releasing the fuel cell from the open circuit state and commencing power generation (steps 204 and 205).

The number of times the fuel cell is brought into an open circuit state since power generation was started is counted up (step 206). In a case where the voltage is determined not to increase even when the count has exceeded a predetermined number of times the fuel cell is brought into an open circuit state (a threshold value) (step 207), the fuel cell shifts to a normal power generation stop mode in which the load is disconnected from the fuel cell 4 to thereby forcefully stop the fuel cell.

Power generation is first stopped (step 208), and at least the oxidant gas supply is subsequently stopped (step 209).

Since hydrogen that is a fuel gas is present around the fuel electrode 2, the voltage of the stack can be deemed to be substantially equal to the electric potential of the oxidant electrode 3. When the electric potential of the oxidant electrode 3 has decreased to about 0V to 0.2V or when a time equivalent to a period of decrease in electric potential has elapsed (step 210), the oxidant gas supply to the oxidant electrode 3 is resumed (step 211). When the oxidant gas supply is started, the electric potential of the oxidant electrode 3 starts increasing, to thus reach the natural electric potential.

The load is connected to the fuel cell 4, and power generation is resumed (step 212).

According to the present embodiment, if the voltage is not recovered even when the fuel cell has been brought into an open circuit state a plurality of times or more during power generation, the electric potential of the oxidant electrode 3 is decreased from a high electric potential (the natural electric potential) to a low electric potential by means of deactivating the fuel cell. The oxidant electrode 3 thus changes from an oxidized state to a reduced state, so that the activity of the oxidant electrode 3 can be recovered.

As a result of the fuel cell being brought into an open circuit state, the impurities adhered to the oxidant electrode 3 are oxidized. Hence, the thus-oxidized impurities can be dissolved in condensed water caused by deactivation or water generated during power generation, and resultant dissolved impurities can be discharged out of the system. Thus, influence of the impurities can further be lessened by combination of the open circuit state with deactivation.

### (Fourth Illustrative Embodiment) not part of the present invention

Fig. 1 is a general configuration of a fuel cell power generation system of a fourth illustrative embodiment.

The fuel cell power generation system of the fourth illustrative embodiment is based on the fuel cell power generation system of the second illustrative embodiment. The fuel cell power generation system of the present illustrative embodiment is identical with the fuel cell power generation system of the second illustrative embodiment except the followings. Namely, the output control unit 11 disconnects the load from the fuel cell 4 for a predetermined period of time with the pressure of the fuel gas supplied to the fuel electrode 2 maintained lower than the pressure of the oxidant gas supplied to the oxidant electrode 3, thereby bringing the fuel cell 4 into an open circuit state to thus activate the oxidant electrode 3. Detailed descriptions are given to a difference between the second embodiment and the fourth embodiment.

In the configuration of the illustrative embodiment, the determination unit 12 of any of the first through third embodiments determines timing when the fuel cell is brought into an open circuit state before an irreversible voltage fall is caused by impurities. The pressure of the fuel gas is made lower than the pressure of the oxidant gas at the timing determined by the determination unit 12. Subsequently, the output control unit 11 disconnects the load from the fuel cell 4 for a predetermined period of time, thereby bringing the fuel cell 4 into an open circuit state.

In the present illustrative embodiment, the pressure of the fuel gas is made lower than the pressure of the oxidant gas, thereby causing a decrease in amount of hydrogen cross-leaking from the fuel electrode 2 toward the oxidant electrode 3. The electric potential of the oxidant electrode 3 can be further increased, so that the impurities adhered to the oxidant electrode 3 become more susceptible to oxidation and that the oxidant electrode can be activated to a much greater extent.

Pressure of the fuel gas supplied to the fuel electrode 2 is decreased by means of decreasing the flow rate of the fuel gas.

As shown in Fig. 1, a fuel cell bypass line 15 is provided so as to bypass the fuel electrode 2 of the fuel cell 4. Only when the fuel cell 4 is activated, a portion of fuel gas is supplied to the fuel cell bypass line 15, thereby decreasing the amount of fuel gas supplied to the fuel electrode 2. The pressure of the fuel gas is maintained so as to become lower than the pressure of the oxidant gas supplied to the oxidant electrode 3. The fuel gas generated by the fuel processing unit 8 can be supplied with a constantly-maintained total amount of the fuel gas, so that control of the fuel processing unit 8 can be simplified.

### (Fifth Illustrative Embodiment) not part of the present invention

Fig. 1 shows a general configuration of a fuel cell power generation system of a fifth illustrative embodiment of the present invention.

The fuel cell power generation system of the fifth illustrative embodiment is analogous to the fuel cell power generation system of the second illustrative embodiment except the following point. The output control unit 11 forcefully decreases an output of the fuel cell 4 at the time that is determined by the determination unit 12 as timing for bringing the fuel cell 4 into an open circuit state. After the amount of fuel gas and the amount of oxidant gas have decreased to their predetermined supply amounts at a predetermined output level or less, the load is disconnected from the fuel cell 4, to thus bring the fuel cell 4 into an open circuit state. Detailed descriptions are given to a difference between the present embodiment and the second embodiment.

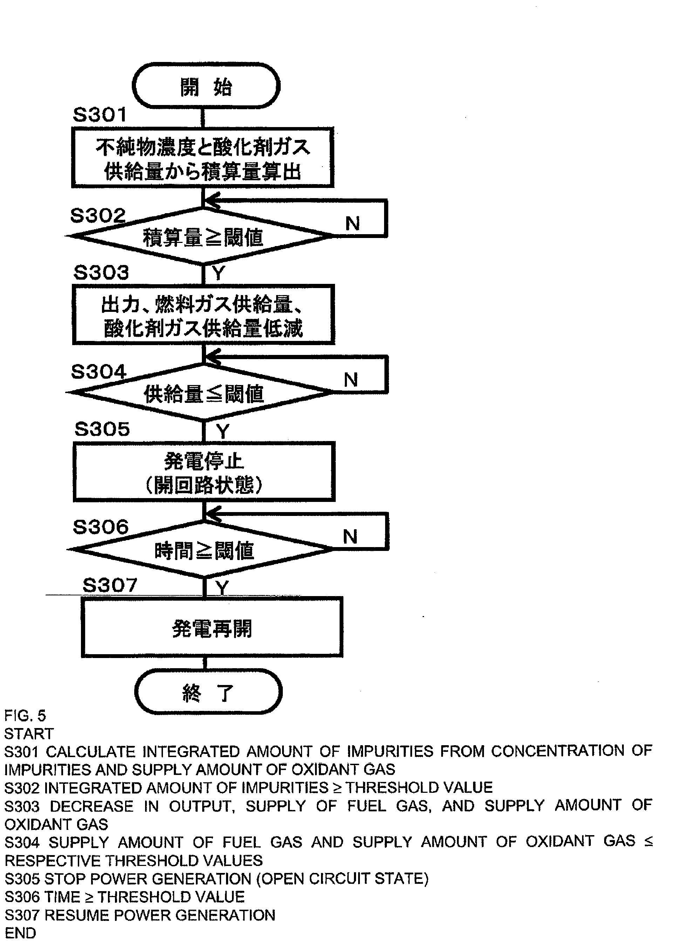

An operation sequence of the fuel cell power generation system of the fifth illustrative embodiment is described by reference to a flowchart of Fig. 5.

First, the determination unit 12 calculates an integrated amount of impurities from the concentration of sulfur dioxide detected by the impurity concentration detection unit 13, a ratio of sulfur dioxide removed by the impurity removal unit 92, and the amount of oxidant gas supplied from the blower 91 to the oxidant electrode 3 since power generation was started (step 301).

A determination is now made as to whether or not the integrated amount determined in step 301 is greater than the threshold value for the integrated amount previously determined by way of experiment (step 302).

If the integrated amount is in excess of the threshold value, the output of the fuel cell 4 is forcefully decreased. The supply amount of the fuel gas and the supply amount of the oxidant gas are correspondingly decreased (step 303). The output, the supply amount of fuel gas, and the supply amount of oxidant gas are set to the minimum output and corresponding supply amounts of the fuel cell power generation system.

When the supply amount of fuel gas and the supply amount of oxidant gas have reached threshold values, there is maintained for a given period of time (about one second to ten minutes) an open circuit state in which the load is disconnected from the fuel cell 4 with the fuel gas supplied to the fuel electrode 2 and the oxidant gas supplied to the oxidant electrode 3 (steps 304 and 305). As a consequence, power generation of the fuel cell is brought into a halt. Hence, power generation is depicted as being halted in Fig. 5.

After the fuel cell has been held in the open circuit state for about one second to ten minutes, the load is again connected to the fuel cell 4, thereby stopping the open circuit state of the fuel cell and starting power generation (steps 306 and 307).

According to the fuel cell power generation system of the fourth illustrative embodiment, power generation is halted at a small output at which the consumed amount of fuel gas and the consumed amount of oxidant gas are small. Therefore, the amount of fuel gas and the amount of oxidant gas that are consumed but not used for power generation can be minimized, so that the fuel cell can be made active with superior efficiency.

Fig. 6 shows a behavior of the stack voltage appearing before and after the fuel cell is brought into an open circuit state. After the time "t" elapsed before the integrated amount of impurities reaches the limit amount at which a voltage fall occurs since power generation was started, the output of the fuel cell 4 is decreased, and the supply amount of fuel gas and the supply amount of oxidant gas are also decreased simultaneously. The voltage of the stack has increased at this time. Further, immediately after the stack voltage increased, the fuel cell is brought into an open circuit state in which the load is disconnected from the fuel cell 4 with the fuel gas supplied to the fuel electrode 2 and with the oxidant gas supplied to the oxidant electrode 3. Further, the stack voltage is again increased, and the voltage of the open circuit is held for about 10 seconds.

The load is later reconnected, and the supply amount of fuel gas and the supply amount of oxidant gas are increased in order to return the fuel cell into the original state of power generation, thereby increasing the output of the fuel cell 4. Similar activation processing is again performed after elapse of time "t" from a point in time when the fuel cell was brought into an open circuit state, to thus become active.

The integrated amount of impurities achieved at time "t" remains constant. Since the constant integrated amount of impurities are thoroughly removed by the same operation, to thus make the fuel cell active, a fuel cell power generation system exhibiting high resistance to impurities can be produced.

Incidentally, the fuel cell power generation system uses a city gas as a source gas. For this reason, a gas supply line is sometimes equipped with a safety device that is called a microcomputer meter. The microcomputer meter is a gas meter that monitors a flow rate of the gas and has a capability of automatically shutting off the supply of gas in case of escape of gas.

For instance, when the consumed amount of the gas remains constant for a given period of time and when no variations occurred in a constant flow rate, a gas is determined to escape and therefore shut off. In the meantime, there is a high probability of a fuel cell power generation system being continually used when compared with another gas apparatus. When electric power is generated at a given output, gas may be shut off in spite of no escape of gas.

Forceful shutoff of gas will arouse an apprehension that an energy saving characteristic will be deteriorated and that durability of an apparatus will be affected. For these reasons, there is a known technique of forcefully changing and decreasing an output of a fuel cell power generation system when power generation is continually performed at a given output for a given period of time or more, thereby changing the amount of gas used.

When the predetermined period of time during which electric power is continually generated at a given output is shorter than the time "t" of the present invention that elapses before the integrated amount of impurities reaches the limit amount at which a voltage fall is caused, an output may be decreased in order to prevent occurrence of false detection of the microcomputer meter. The fuel cell 4 may be brought into an open circuit state at timing at which the supply amount of fuel gas and the supply amount of oxidant gas are decreased only for a short period of time, thereby making the oxidant electrode 3 active. So long as the oxidant electrode is made active at this timing, the efficiency of power generation and durability of the fuel cell 4 can be enhanced more effectively.

In the second through fifth embodiments, a configuration for disconnecting the load from the fuel cell 4, to thus bring the fuel cell into an open circuit state, has been described as a configuration for applying a predetermined voltage or more to the oxidant electrode 3. The predetermined voltage or more may also be any choice from a voltage that is higher than that achieved during normal operation of the fuel cell 4, a voltage required to oxidize the impurities adhered to the oxidant electrode 4, and a voltage produced when a load of the fuel cell power generation system is made small load.

The output control unit 11 has been described in connection with the state in which the fuel electrode 2 is supplied with the fuel gas and in which the oxidant electrode 3 is supplied with the oxidant gas. However, there may also be adopted a state in which the supply of the fuel gas to the fuel electrode 2 and the supply of the oxidant gas to the oxidant electrode 3 are respectively halted.

The present patent application is based on Japanese Patent Application No. 2008-221401 filed on August 29, 2008.

### Industrial Applicability

The fuel cell power generation system of the present invention exhibits an effect of increasing an electric potential of an oxidant electrode according to an integrated amount of impurities included in an oxidant gas and supplied to the oxidant electrode, thereby making a fuel cell active and enhancing efficiency of power generation and durability. The fuel cell power generation system is useful for a fuel cell, a fuel cell device, and a stationary fuel cell cogeneration system that each use a solid polymer electrolyte.

### Description of Reference Signs

- 1: ELECTROLYTE
- 2: FUEL ELECTRODE
- 3: OXIDANT ELECTRODE
- 4: FUEL CELL
- 11: OUTPUT CONTROL UNIT
- 12: DETERMINATION UNIT
- 13: IMPURITY CONCENTRATION DETECTION UNIT
- 14: VOLTAGE DETECTION UNIT
- 15: FUEL CELL BYPASS LINE

## Claims

1. A fuel cell power generation system configured to generate electric power by a reaction of a fuel gas and an oxidant gas, said fuel cell power generation system comprising:
a fuel cell (4) comprising:
a fuel electrode (2) to which a fuel gas containing at least hydrogen is supplied;
an oxidant electrode (3) to which an oxidant gas containing at least oxygen is supplied; and
an electrolyte (1) on which the fuel electrode and the oxidant electrode are formed;
an output control unit (11) configured to apply a predetermined voltage or more to the oxidant electrode, with no electric power supplied to an outside of the fuel cell power generation system; and
a determination unit (12) configured to determine timing at which the output control unit (11) applies the predetermined voltage or more,
wherein the output control unit (11) is configured to:
perform a normal operation by supplying power to an internal load of the fuel cell power generation system and an external load, and
perform a control, at the timing for applying the predetermined voltage or more, to cut a connection between the external load and the fuel cell (4), thereby applying a voltage higher than that applied during the normal operation and lower than that obtained during an open circuit state to the oxidant electrode (3),
**characterized in that**
the output control unit (11) is configured to perform the control to apply the predetermined voltage or more to the oxidant electrode (3) in a state in which supply of the fuel gas to the fuel electrode (2) is stopped, supply of the oxidant gas to the oxidant electrode (3) is stopped, and the connection between the external load and the fuel cell (4) is cut.

2. The fuel cell power generation system according to claim 1,
wherein the output control unit (11) is configured to perform the control, at the timing for applying the predetermined voltage or more, to supply power to all or a part of the internal load of the fuel cell power generation system, thereby applying a voltage higher than that applied during the normal operation and lower than that obtained during the open circuit state to the oxidant electrode (3).

3. The fuel cell power generation-system according to claim 1 or 2,
wherein the output control unit (11) is configured to perform the control to apply the predetermined voltage or more to the oxidant electrode (3) in a state in which a fuel gas is supplied to the fuel electrode (2), an oxidant gas is supplied to the oxidant electrode (3), and the connection between the external load and the fuel cell (4) is cut.

4. The fuel cell power generation system according to any one of claims 1 to 3,
wherein the determination unit (12) comprises a power generation time integration unit configured to integrate a power generation time of the fuel cell (4), and is configured to determine the timing at which the predetermined voltage or more is applied to the oxidant electrode (3) based on an integrated time obtained by the power generation time integration unit.

5. The fuel cell power generation system according to any one of claims 1 to 4,
wherein the impurities contained in the oxidant gas are sulfur compounds.

6. The fuel cell power generation system according to any one of claims 1 to 3, comprising:
a voltage detection unit (14) configured to detect a voltage of the fuel cell (4) during power generation,
wherein the determination unit (12) is configured to calculate an integrated amount of impurities supplied to the oxidant electrode (3) based on the voltage detected by the voltage detection unit (14), and determine the timing at which the predetermined voltage or more is applied to the oxidant electrode (3).

7. The fuel cell power generation system according to claim 6,
wherein, when a number of times the predetermined voltage or more is applied to the oxidant electrode (3) exceeds a predetermined number of times from a start of the power generation and when the voltage detected by the voltage detection unit (14) falls below the predetermined voltage for a given period of time, the output control unit (11) is configured to:
stop power generation of the fuel cell and stops at least the supply of the oxidant gas so as to decrease an electric potential of the oxidant electrode (3) to a predetermined electric potential;
thereafter again supply the oxidant gas so as to bring the fuel cell into an open circuit state for a given period of time; and
thereafter start power generation of the fuel cell.

8. The fuel cell power generation system according to claim 1,
wherein the output control unit (11) is configured to cause a pressure of the fuel gas supplied to the fuel electrode (2) to be maintained so as to become lower than a pressure of the oxidant gas supplied to the oxidant electrode (3).

9. The fuel cell power generation system according to claim 1,
wherein the output control unit (11) is configured to cause a pressure of the fuel gas to be maintained so as to become lower than a pressure of the oxidant gas supplied to the oxidant electrode (3) by decreasing a flow rate of the fuel gas supplied to the fuel electrode (2).

10. The fuel cell power generation system according to claim 8, comprising:
a fuel cell bypass line (15) configured to bypass the fuel electrode (2) of the fuel cell (4),
wherein the output control unit (11) is configured to cause the pressure of the fuel gas to be maintained so as to become lower than the pressure of the oxidant gas supplied to the oxidant electrode (3) by supplying a part of the fuel gas to the fuel cell bypass line (15) thereby decreasing the flow rate of the fuel gas supplied to the fuel electrode (2).

11. The fuel cell power generation system according to any one of claims 1 to 3,
wherein the output control unit (11) is configured to:
control a supply amount of the fuel gas and a supply amount of oxidant gas according to fluctuations in a load of the fuel cell (4), thereby controlling an output of the fuel cell (4);
forcefully decrease the output of the fuel cell (4) to the external load to which the fuel cell (4) supplies the power, at the time determined by the determination unit (12), thereby decreasing the amount of fuel gas and the amount of oxidant gas to predetermined supply amounts under a predetermined output or less; and
thereafter perform the control to apply the predetermined voltage or more to the oxidant electrode (3) in the state in which the connection between the external load and the fuel cell (4) is cut.

## Patentansprüche

1. Brennstoffzellen-Energieerzeugungssystem, das so eingerichtet ist, dass es elektrische Energie durch eine Reaktion eines Brennstoff-Gases und eines Oxidans-Gases erzeugt, wobei das Brennstoffzellen-Energieerzeugungssystem umfasst:
eine Brennstoffzelle (4), die umfasst:
eine Brennstoff-Elektrode (2), der ein Brennstoff-Gas zugeführt wird, das wenigstens Wasserstoff enthält;
eine Oxidans-Elektrode (3), der ein Oxidans-Gas zugeführt wird, das wenigstens Sauerstoff enthält; sowie
ein Elektrolyt (1), an dem die Brennstoff-Elektrode und die Oxidans-Elektrode ausgebildet sind;
eine Ausgabe-Steuereinheit (11), die so eingerichtet ist, dass sie eine vorgegebene oder höhere Spannung an die Oxidans-Elektrode anlegt, ohne dass einer Außenseite des Brennstoffzellen-Ernergieerzeugungssystems elektrische Energie zugeführt wird; und
eine Bestimmungseinheit (12), die so eingerichtet ist, dass sie die Zeit bestimmt, zu der die Ausgabe-Steuereinheit (11) die vorgegebene oder höhere Spannung anlegt,
wobei die Ausgabe-Steuereinheit (11) so eingerichtet ist, dass sie:
einen normalen Betrieb durchführt, indem sie einer internen Last des Brennstoffzellen-Energieerzeugungssystems und einer externen Last Energie zuführt, und
zu der Zeit zum Anlegen der vorgegebenen oder höheren Spannung eine Steuerung durchführt, um eine Verbindung zwischen der externen Last und der Brennstoffzelle (4) zu trennen und so eine Spannung, die höher ist als die während des normalen Betriebes angelegte und niedriger ist als die während eines Leerlaufzustandes gewonnene, an die Oxidans-Elektrode (3) anzulegen,
**dadurch gekennzeichnet, dass**
die Ausgabe-Steuereinheit (11) so eingerichtet ist, dass sie die Steuerung zum Anlegen der vorgegebenen oder höheren Spannung an die Oxidans-Elektrode (3) in einem Zustand durchführt, in dem Zufuhr des Brennstoffgases zu der Brennstoff-Elektrode (2) unterbrochen ist, Zufuhr des Oxidans-Gases zu der Oxidans-Elektrode (3) unterbrochen ist und die Verbindung zwischen der externen Last und der Brennstoffzelle (4) getrennt ist.

2. Brennstoffzellen-Energieerzeugungssystem nach Anspruch 1,
wobei die Ausgabe-Steuereinheit (11) so eingerichtet ist, dass sie die Steuerung zu der Zeit zum Anlegen der vorgegebenen oder höheren Spannung durchführt, um der gesamten internen Last des Brennstoffzellen-Energieerzeugungssystems oder einem Teil derselben Energie zuzuführen und so eine Spannung, die höher ist als die während des normalen Betriebes angelegte und niedriger als die während des Leerlaufzustandes gewonnene, an die Oxidans-Elektrode (3) anzulegen.

3. Brennstoffzellen-Energieerzeugungssystem nach Anspruch 1 oder 2,
wobei die Ausgabe-Steuereinheit (11) so eingerichtet ist, dass sie die Steuerung zum Anlegen der vorgegebenen oder höheren Spannung an die Oxidans-Elektrode (3) in einem Zustand durchführt, in dem der Brennstoff-Elektrode (2) ein Brennstoff-Gas zugeführt wird, der Oxidans-Elektrode (3) ein Oxidans-Gas zugeführt wird und die Verbindung zwischen der externen Last und der Brennstoffzelle (4) getrennt ist.

4. Brennstoffzellen-Energieerzeugungssystem nach einem der Ansprüche 1 bis 3,
wobei die Bestimmungseinheit (12) eine Einheit zum Integrieren einer Zeit für Energieerzeugung umfasst, die so eingerichtet ist, dass sie eine Zeit für Energieerzeugung der Brennstoffzelle (4) integriert, und sie so eingerichtet ist, dass sie die Zeit, zu der die vorgegebene oder höhere Spannung an die Oxidans-Elektrode (3) angelegt wird, auf Basis der durch die Einheit zum Integrieren einer Zeit für Energieerzeugung ermittelten integrierten Zeit bestimmt.

5. Brennstoffzellen-Energieerzeugungssystem nach einem der Ansprüche 1 bis 4,
wobei die in dem Oxidans-Gas enthaltenen Verunreinigungen Schwefelverbindungen sind.

6. Brennstoffzellen-Energieerzeugungssystem nach einem der Ansprüche 1 bis 3, das umfasst:
eine Spannungs-Erfassungseinheit (14), die so eingerichtet ist, dass sie eine Spannung der Brennstoffzelle (4) bei Energieerzeugung erfasst,
wobei die Bestimmungseinheit (12) so eingerichtet ist, dass sie eine integrierte Menge der Oxidans-Elektrode (3) zugeführter Verunreinigungen auf Basis der durch die Spannungs-Erfassungseinheit (14) erfassten Spannung berechnet und die Zeit bestimmt, zu der die vorgegebene oder höhere Spannung an die Oxidans-Elektrode (3) angelegt wird.

7. Brennstoffzellen-Energieerzeugungssystem nach Anspruch 6,
wobei die Ausgabe-Steuereinheit (11) so eingerichtet ist, dass sie, wenn eine Häufigkeit, mit der die vorgegebene oder höhere Spannung an die Oxidans-Elektrode (3) angelegt wird, eine Häufigkeit von einem Beginn der Energieerzeugung an übersteigt und die durch die Spannungs-Erfassungseinheit (14) erfasste Spannung über einen gegebenen Zeitraum unter die vorgegebene Spannung fällt:
Energieerzeugung der Brennstoffzelle unterbricht und wenigstens die Zufuhr des Oxidans-Gases unterbricht, um ein elektrisches Potential der Oxidans-Elektrode (3) auf ein vorgegebenes elektrisches Potential zu verringern;
danach das Oxidans-Gas erneut zuführt, um die Brennstoffzelle über einen gegebenen Zeitraum in einen Leerlaufzustand zu versetzen; und
danach Energieerzeugung der Brennstoffzelle in Gang setzt.

8. Brennstoffzellen-Energieerzeugungssystem nach Anspruch 1,
wobei die Ausgabe-Steuereinheit (11) so eingerichtet ist, dass sie bewirkt, dass ein Druck des der Brennstoff-Elektrode (2) zugeführten Brennstoff-Gases so gehalten wird, dass er niedriger wird als ein Druck des der Oxidans-Elektrode (3) zugeführten Oxidans-Gases.

9. Brennstoffzellen-Energieerzeugungssystem nach Anspruch 1,
wobei die Ausgabe-Steuereinheit (11) so eingerichtet ist, dass sie bewirkt, dass ein Druck des Brennstoff-Gases so gehalten wird, dass er niedriger wird als ein Druck des der Oxidans-Elektrode (3) zugeführten Oxidans-Gases, indem sie eine Strömungsgeschwindigkeit des der Brennstoff-Elektrode (2) zugeführten Brennstoff-Gases verringert.

10. Brennstoffzellen-Energieerzeugungssystem nach Anspruch 8, das umfasst:
eine Brennstoffzellen-Umgehungsleitung (15), die so eingerichtet ist, dass sie die Brennstoff-Elektrode (2) der Brennstoffzelle (4) umgeht,
wobei die Ausgabe-Steuereinheit (11) so eingerichtet ist, dass sie bewirkt, dass der Druck des Brennstoff-Gases so gehalten wird, dass er niedriger wird als der Druck des der Oxidans-Elektrode (3) zugeführten Oxidans-Gases, indem sie einen Teil des Brennstoff-Gases der Brennstoffzellen-Umgehungsleitung (15) zuführt und so die Strömungsgeschwindigkeit des der Brennstoff-Elektrode (2) zugeführten Brennstoff-Gases verringert.

11. Brennstoffzellen-Energieerzeugungssystem nach einem der Ansprüche 1 bis 3, wobei die Ausgabe-Steuereinheit (11) so eingerichtet ist, dass sie:
eine zugeführte Menge des Brennstoffgases und eine zugeführte Menge an Oxidans-Gas entsprechend Schwankungen einer Last der Brennstoff-Zelle (4) steuert und so eine Ausgabe der Brennstoffzelle (4) steuert;
die Ausgabe der Brennstoffzelle (4) an die externe Last, der die Brennstoffzelle (4) die Energie zuführt, zu der durch die Bestimmungseinheit (12) bestimmten Zeit zwangsweise verringert, um so die Menge an Brennstoff-Gas und die Menge an Oxidans-Gas auf vorgegebene Zuführmengen unter einer vorgegebenen oder geringeren Ausgabe zu verringern; und
anschließend die Steuerung zum Anlegen der vorgegebenen oder höheren Spannung an die Oxidans-Elektrode (3) in dem Zustand durchführt, in dem die Verbindung zwischen der externen Last und der Brennstoffzelle (4) getrennt ist.

## Revendications

1. Système de génération d'énergie à pile à combustible configuré pour générer de l'énergie électrique par une réaction d'un gaz combustible et d'un gaz oxydant, ledit système de génération d'énergie à pile à combustible comprenant :
- une pile à combustible (4) comprenant :
- une électrode de combustible (2) à laquelle un gaz combustible contenant au moins de l'hydrogène est délivré ;
- une électrode d'oxydant (3) à laquelle un gaz oxydant contenant au moins de l'oxygène est délivré ; et
- un électrolyte (1) sur lequel l'électrode de combustible et l'électrode d'oxydant sont formées ;
- une unité de commande de sortie (11) configurée pour appliquer une tension prédéterminée ou supérieure à l'électrode d'oxydant, avec aucune énergie électrique délivrée à un extérieur du système de génération d'énergie à pile à combustible ; et
- une unité de détermination (12) configurée pour déterminer la chronologie à laquelle l'unité de commande de sortie (11) applique la tension prédéterminée ou supérieure,
- dans lequel l'unité de commande de sortie (11) est configurée pour :
- effectuer une opération normale en délivrant de l'énergie à une charge interne du système de génération d'énergie à pile à combustible et à une charge externe ; et
- effectuer une commande, à la chronologie d'application de la tension prédéterminée ou supérieure, pour couper une connexion entre la charge externe et la pile à combustible (4), appliquant ainsi une tension supérieure à celle appliquée durant l'opération normale et inférieure à celle obtenue durant un état de circuit ouvert à l'électrode d'oxydant (3),
- **caractérisé en ce que** :
- l'unité de commande de sortie (11) est configurée pour effectuer la commande pour appliquer la tension prédéterminée ou supérieure à l'électrode d'oxydant (3) dans un état dans lequel une délivrance du gaz combustible à l'électrode de combustible (2) est arrêtée, une délivrance du gaz oxydant à l'électrode d'oxydant (3) est arrêtée et la connexion entre la charge externe et la pile à combustible (4) est coupée.

2. Système de génération d'énergie à pile à combustible selon la revendication 1,
- dans lequel l'unité de commande de sortie (11) est configurée pour effectuer la commande, à la chronologie d'application de la tension prédéterminée ou supérieure, pour délivrer de l'énergie à la totalité ou une partie de la charge interne du système de génération d'énergie à pile à combustible, appliquant ainsi une tension supérieure à celle appliquée durant l'opération normale et inférieure à celle obtenue durant l'état de circuit ouvert à l'électrode d'oxydant (3).

3. Système de génération d'énergie à pile à combustible selon les revendications 1 ou 2,
- dans lequel l'unité de commande de sortie (11) est configurée pour effectuer la commande pour appliquer la tension prédéterminée ou supérieure à l'électrode d'oxydant (3) dans un état dans lequel un gaz combustible est délivré à l'électrode de combustible (2), un gaz oxydant est délivré à l'électrode d'oxydant (3) et la connexion entre la charge externe et la pile à combustible (4) est coupée.

4. Système de génération d'énergie à pile à combustible selon l'une quelconque des revendications 1 à 3,
- dans lequel l'unité de détermination (12) comprend une unité d'intégration du temps de génération d'énergie, configurée pour intégrer un temps de génération d'énergie de la pile à combustible (4), et est configurée pour déterminer la chronologie à laquelle la tension prédéterminée ou supérieure est appliquée à l'électrode d'oxydant (3) en se fondant sur un temps intégré par l'unité d'intégration du temps de génération d'énergie.

5. Système de génération d'énergie à pile à combustible selon l'une quelconque des revendications 1 à 4,
- dans lequel les impuretés contenues dans le gaz oxydant sont des composés sulfurés.

6. Système de génération d'énergie à pile à combustible selon l'une quelconque des revendications 1 à 3, comprenant :
- une unité de détection de tension (14) configurée pour détecter une tension de la pile à combustible (4) durant une génération d'énergie,
- une unité de détermination (12) est configurée pour calculer une quantité intégrée d'impuretés délivrée à l'électrode d'oxydant (3), en se fondant sur la tension détectée par l'unité de détection de tension (14), et déterminer la chronologie à laquelle la tension prédéterminée ou supérieure est appliquée à l'électrode d'oxydant (3).

7. Système de génération d'énergie à pile à combustible selon la revendication 6,
- dans lequel, lorsqu'un nombre de fois auquel la tension prédéterminée ou supérieure est appliquée à l'électrode d'oxydant (3) excède un nombre prédéterminé de fois depuis un démarrage de la génération d'énergie et lorsque la tension détectée par l'unité de détection de tension (14) chute au-dessous de la tension prédéterminée pendant une période de temps donnée, l'unité de commande de sortie (11) est configurée pour :
- arrêter une génération d'énergie de la pile à combustible et arrête la délivrance du gaz oxydant de façon à réduire un potentiel électrique de l'électrode d'oxydant à un potentiel électrique prédéterminé ;
- ensuite délivrer à nouveau le gaz oxydant de façon à amener la pile à combustible à un état de circuit ouvert pendant une période de temps donnée ; et
- puis démarrer une génération d'énergie de la pile à combustible.

8. Système de génération d'énergie à pile à combustible selon la revendication 1,
- dans lequel l'unité de commande de sortie (11) est configurée pour faire en sorte qu'une pression du gaz combustible délivré à l'électrode de combustible (2) soit maintenue de façon à devenir inférieure à une pression du gaz oxydant délivré à l'électrode d'oxydant (3).

9. Système de génération d'énergie à pile à combustible selon la revendication 1,
- dans lequel l'unité de commande de sortie (11) est configurée pour faire en sorte qu'une pression du gaz combustible soit maintenue de façon à devenir inférieure à une pression du gaz oxydant délivré à l'électrode d'oxydant (3) en réduisant un débit du gaz combustible délivré à l'électrode de combustible (2).

10. Système de génération d'énergie à pile à combustible selon la revendication 8, comprenant :
- une ligne de dérivation de pile à combustible (15) configurée pour dériver l'électrode de combustible (2) de la pile à combustible (4),
- dans lequel l'unité de commande de sortie (11) est configurée pour faire en sorte que la pression du gaz combustible soit maintenue de façon à devenir inférieure à la pression du gaz oxydant délivré à l'électrode d'oxydant (3) en délivrant une partie du gaz combustible à la ligne de dérivation de pile à combustible (15) en réduisant ainsi le débit du gaz combustible délivré à l'électrode de combustible (2).

11. Système de génération d'énergie à pile à combustible selon l'une quelconque des revendications 1 à 3,
- dans lequel l'unité de commande de sortie (11) est configurée pour :
- commander une quantité délivrée du gaz combustible et une quantité délivrée d'un gaz oxydant suivant des fluctuations dans une charge de la pile à combustible (4), en commandant ainsi une sortie de la pile à combustible (4) ;
- réduire vigoureusement la sortie de la pile à combustible (4) à la charge externe à laquelle la pile à combustible (4) délivre l'énergie, au moment déterminé par l'unité de détermination (12), en réduisant ainsi la quantité de gaz combustible et la quantité de gaz oxydant à des quantités de délivrance prédéterminées au-dessous d'une sortie prédéterminée ou inférieure ; et
- puis effectuer la commande afin d'appliquer la tension prédéterminée ou supérieure à l'électrode d'oxydant (3) dans l'état dans lequel la connexion entre la charge externe et la pile à combustible (4) est coupée.
